(19) Europäisches Patentamt
European Patent Office
Office européen des brevets

(11) **EP 3 036 511 B1**

(12) **EUROPÄISCHE PATENTSCHRIFT**

(45) Veröffentlichungstag und Bekanntmachung des Hinweises auf die Patenterteilung:
**10.11.2021   Patentblatt 2021/45**

(21) Anmeldenummer: **14755590.8**

(22) Anmeldetag: **11.08.2014**

(51) Int Cl.:
*G01F 1/56* (2006.01)        *G01F 1/74* (2006.01)
*G01F 1/58* (2006.01)        *G01R 33/563* (2006.01)
*G01N 24/08* (2006.01)      *G01R 33/34* (2006.01)
*G01R 33/44* (2006.01)

(86) Internationale Anmeldenummer:
**PCT/EP2014/002204**

(87) Internationale Veröffentlichungsnummer:
**WO 2015/024636 (26.02.2015 Gazette 2015/08)**

(54) **KERNMAGNETISCHES DURCHFLUSSMESSGERÄT UND VERFAHREN ZUM BETREIBEN VON KERNMAGNETISCHEN DURCHFLUSSMESSGERÄTEN**

NUCLEAR MAGNETIC FLOWMETER AND METHOD FOR OPERATING NUCLEAR MAGNETIC FLOWMETERS

DÉBITMÈTRE NUCLÉAIRE MAGNÉTIQUE ET PROCÉDÉ PERMETTANT DE FAIRE FONCTIONNER DES DÉBITMÈTRES NUCLÉAIRES MAGNÉTIQUES

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **21.08.2013   DE 102013013745**
**24.02.2014   DE 102014002392**

(43) Veröffentlichungstag der Anmeldung:
**29.06.2016   Patentblatt 2016/26**

(73) Patentinhaber: **Krohne AG**
**4019 Basel (CH)**

(72) Erfinder:
• **HOGENDOORN, Cornelis Johannes**
**NL-4211 BG Spijk (NL)**
• **TROMP, Rutger Reinout**
**NL-3311 EM Dordrecht (NL)**
• **ZOETEWEIJ, Marco Leendert**
**NL -3344 EP Hendrik-Ido-Ambach (NL)**
• **FREEMAN, John Justin**
**Brookshire, TX 77423 (US)**
• **APPEL, Matthias**
**Houston, TX 77077 (US)**

(74) Vertreter: **Gesthuysen Patentanwälte**
**Patentanwälte**
**Huyssenallee 100**
**45128 Essen (DE)**

(56) Entgegenhaltungen:
**SU-A1- 819 657        US-A- 4 613 818**
**US-A- 4 638 251        US-A1- 2012 092 007**

• **None**

# EP 3 036 511 B1

## Beschreibung

Die Erfindung betrifft ein kernmagnetisches Durchflussmessgerät zur Bestimmung des Durchflusses eines durch ein Messrohr strömenden Mediums, mit einer Magnetfelderzeugungseinrichtung, einer Messeinrichtung und einer Antenneneinrichtung mit einer Antenne, wobei die Magnetfelderzeugungseinrichtung über eine parallel zur Messrohrlängsachse ausgerichtete Magnetfeldstrecke das strömende Medium mit einem zumindest eine zur Messrohrlängsachse senkrechte Komponente aufweisenden Magnetfeld zur Magnetisierung des Mediums durchsetzt, wobei die Messeinrichtung zur Erzeugung von das magnetisierte Medium anregenden Anregungssignalen und zur Messung der von den Anregungssignalen im magnetisierten Medium hervorgerufenen Messsignale ausgebildet ist und wobei die Antenne spulenartig ausgebildet ist und über eine parallel zur Messrohrlängsachse ausgerichtete und in der Magnetfeldstrecke liegende Messstrecke zur Übertragung der Anregungssignale auf das magnetisierte Medium und zur Detektion der Messsignale ausgebildet ist. Darüber hinaus betrifft die Erfindung auch ein Verfahren zum Betreiben von kernmagnetischen Durchflussmessgeräten.

Die Atomkerne der Elemente, die einen Kernspin besitzen, besitzen auch ein durch den Kernspin hervorgerufenes magnetisches Moment $\mu$. Der Kernspin kann als ein durch einen Vektor beschreibbarer Drehimpuls aufgefasst werden und entsprechend kann auch das magnetische Moment durch einen Vektor $\vec{\mu}$ beschrieben werden, der parallel zum Vektor des Drehimpulses ausgerichtet ist. Der Vektor des magnetischen Moments eines Atomkerns richtet sich bei Anwesenheit eines makroskopischen Magnetfelds tendenziell parallel zum Vektor des makroskopischen Magnetfelds am Ort des Atomkerns aus. Dabei präzessiert der Vektor des magnetischen Moments des Atomkerns um den Vektor des makroskopischen Magnetfelds am Ort des Atomkerns. Die Kreisfrequenz der Präzession wird als Larmorkreisfrequenz bezeichnet und ist das Produkt aus dem gyromagnetischen Verhältnis und dem Betrag der magnetischen Flussdichte am Ort des Atomkerns. Folglich ist die Larmorkreisfrequenz proportional zum Betrag der magnetischen Flussdichte am Ort des

Atomkerns. Das gyromagnetische Verhältnis ist für Wasserstoffkerne maximal.

Eine Mehrzahl von $K$ Atomkernen in einem Volumen $V$ mit jeweils einem magnetischen Moment $\vec{\mu_k}$ besitzt bei Abwesenheit eines makroskopischen Magnetfelds aufgrund der statistischen Gleichverteilung der Ausrichtungen der einzelnen magnetischen Momente der Atomkerne keine makroskopische Magnetisierung $\vec{M} = \frac{1}{V}\sum_{k=1}^{K}\vec{\mu}_k$. Die Anwesenheit eines makroskopischen Magnetfelds stört die statistische Gleichverteilung der Ausrichtungen der einzelnen magnetischen Momente der Atomkerne, und es bildet sich eine makroskopische Magnetisierung parallel zum makroskopischen Magnetfeld heraus. Der zeitliche Verlauf des Prozesses der Ausrichtung der magnetischen Momente im makroskopischen Magnetfeld ist durch die Spin-Gitter-Relaxationszeitkonstante $T_1$ charakterisiert und weist einen exponentiell abklingenden Verlauf auf. Der Wert der Spin-Gitter-Relaxationszeitkonstanten wiederum ist charakteristisch für verschiedene Substanzen.

Kernmagnetische Durchflussmessgeräte der eingangs beschriebenen Art sind zur Bestimmung des Durchflusses des durch das Messrohr strömenden Mediums ausgebildet. Das Medium kann eine oder auch mehrere Phasen beinhalten. Bei einem einphasigen Medium erfolgt die Bestimmung des Durchflusses durch die Bestimmung der Strömungsgeschwindigkeit des Mediums in dem Messrohr. Die Bestimmung des Durchflusses eines mehrphasigen Mediums beinhaltet neben der Bestimmung der Strömungsgeschwindigkeit jeder der Phasen auch die Bestimmung des Anteils jeder der Phasen am Medium. Jede Phase des Mediums muss dabei Atomkerne mit magnetischen Momenten aufweisen, so dass die Phasen in einem Magnetfeld magnetisierbar sind. Besitzen die Phasen des Mediums unterschiedliche Spin-Gitter-Relaxationszeitkonstanten, sind ihre Anteile am Medium bestimmbar. Das aus Ölquellen geförderte mehrphasige Medium besteht im Wesentlichen aus den beiden flüssigen Phasen Rohöl und Salzwasser und der gasförmigen Phase Erdgas, wobei alle Phasen Wasserstoffkerne enthalten und verschiedene Spin-Gitter-Relaxationszeitkonstanten besitzen. Daher sind kernmagnetische Durchflussmessgeräte der eingangs beschriebenen Art insbesondere zur Durchflussmessung des aus Ölquellen geförderten mehrphasigen Mediums geeignet.

Messverfahren zur Bestimmung der Anteile der einzelnen Phasen am Medium sehen vor, dass die Magnetisierung des Mediums nach verschieden langen Einwirkdauern des von der Magnetfelderzeugungseinrichtung erzeugten Magnetfelds auf das Medium bestimmt wird. Die Bestimmung der Magnetisierung des Mediums nach einer bestimmten Einwirkdauer des Magnetfelds erfolgt durch die Messeinrichtung durch Anregung des magnetisierten Mediums mit Anregungssignalen, Messung der von den Anregungssignalen im magnetisierten Medium hervorgerufenen Messsignale und Auswertung der Messsignale. Die vor der Anregung des Mediums unkorreliert präzessierenden Vektoren der magnetischen Momente der einzelnen Atomkerne werden durch die Anregung korreliert, was zunächst feste Phasenbeziehungen zwischen den präzessierenden Vektoren der magnetischen Momenten bedeutet. Mit nach der Anregung fortschreitender Zeit klingt die Korrelation aufgrund verschiedener Mechanismen jedoch exponentiell ab, was als Dephasierung bezeichnet wird und hier durch die Relaxationszeitkonstante $T_2$ charakterisiert ist. Der Wert der Relaxationszeitkonstanten $T_2$ ist charakteristisch für verschiedene Substanzen. Demnach weisen die Messsignale eine harmonische Schwingung auf, welche durch die Larmorkreisfrequenz und eine exponentiell abklingende Amplitude gekennzeichnet ist. Die Messeinrichtung bestimmt weiter aus verschieden langen Einwirkdauern des Magnetfelds auf das Medium und den dabei bestimmten Magnetisierungen die Anteile der einzelnen Phasen am Medium. Die spulenartig ausgebildete Antenne der Antenneneinrichtung überträgt dabei zum einen die Anregungssignale auf das Medium und detektiert zum anderen die Messsignale des angeregten Mediums. Die Antenneneinrichtung überträgt die Anregungssignale von der Messeinrichtung zur Antenne und überträgt die Messsignale von der Antenne zur Messeinrichtung.

Aus dem Stand der Technik bekannte kernmagnetische Durchflussmessgeräte der eingangs beschriebenen Art variieren die wirksame Einwirkdauer des Magnetfelds auf das Medium durch Veränderung des Magnetfelds, wobei die Veränderung des Magnetfelds durch eine Mechanik bewirkt ist.

Aus der US 7,872,474 B2 ist ein kernmagnetisches Durchflussmessgerät der eingangs beschriebenen Art bekannt. Die Magnetfelderzeugungseinrichtung umfasst mehrere um das Messrohr entlang der Messrohrlängsachse aufeinanderfolgend angeordnete Magnetanordnungen. Jede der Magnetanordnungen ist um die Messrohrlängsachse drehbar und durchsetzt das im Messrohr strömende Medium mit einem eine Richtung aufweisenden Magnetfeld. Die Richtungen der einzelnen Magnetfelder der Magnetanordnungen können dabei entweder parallel oder antiparallel zueinander ausgerichtet sein. Umfasst die Magnetfelderzeugungseinrichtung zum Beispiel vier Magnetanordnungen und sind die Richtungen der Magnetfelder der vier Magnetanordnungen parallel ausgerichtet, ist die wirksame Einwirkdauer des Magnetfelds auf das Medium maximal. Ist die Richtung des Magnetfelds einer der Magnetanordnungen antiparallel zu den Richtungen der Magnetfelder der übrigen drei Magnetanordnungen ausgerichtet, ist die wirksame Einwirkdauer nur noch halb so lang wie zuvor. Denn eine der drei Magnetanordnungen, deren Richtungen der Magnetfelder parallel ausgerichtet sind, kompensiert die durch die Magnetanordnung, deren Richtung des Magnetfelds antiparallel ausgerichtet ist, bewirkte Magnetisierung des Mediums. Das Drehen der einzelnen Magnetbaugruppen erfordert eine entsprechende Mechanik. Diese Mechanik, wie jede Mechanik, ist mit Kosten verbunden, benötigt Platz, muss gewartet werden und ist trotz der Wartung nur begrenzt zuverlässig.

Weitere Beispiele von kernmagnetischen Durchflussmessgeräten sind in der US 4 638 251 A1, in der SU 819657 A1 und in der US 2012/0092007 A1 detailliert beschrieben.

Aufgabe der vorliegenden Erfindung ist die Angabe eines kernmagnetischen Durchflussmessgeräts mit einer verbesserten Zuverlässigkeit und die Angabe eines Verfahrens zum Betreiben von kernmagnetischen Durchflussmessgeräten.

Diese Aufgabe der Erfindung wird durch die im Anspruch 1 angeführten Merkmale gelöst.

Die Antenneneinrichtung umfasst mindestens zwei Antennen, wobei jede der Antennen spulenartig ausgebildet ist und über eine parallel zur Messrohrlängsachse ausgerichtete und in der Magnetfeldstrecke liegende Messstrecke zur Übertragung der Anregungssignale auf das magnetisierte Medium und zur Detektion der Messsignale ausgebildet ist. Jede der Messstrecken ist durch ihre Länge parallel zur Messrohrlängsachse und den Ort auf der Messrohrlängsachse eindeutig bestimmt. Mindestens jeweils zwei der Messstrecken können entweder aufeinanderfolgend oder aber überlappend in der Magnetfeldstrecke liegen.

Durch die verschiedenen Messstrecken der Antennen erfolgt die Anregung des Mediums mit den Anregungssignalen und dann die Detektion der durch die Anregungssignale hervorgerufenen Messsignale des Mediums nach unterschiedlich langen Einwirkdauern des Magnetfelds auf das Medium. Die Einwirkdauer des Magnetfelds auf das Medium ergibt sich unmittelbar aus der Strecke in Strömungsrichtung des Mediums vom Anfang der Magnetfeldstrecke bis zur jeweiligen Antenne und der Strömungsgeschwindigkeit des Mediums im Messrohr.

Das erfindungsgemäße kernmagnetischen Durchflussmessgerät hat gegenüber im Stand der Technik bekannten kernmagnetischen Durchflussmessgeräten der eingangs beschriebenen Art den Vorteil des Entfalls der Mechanik zur Variation der wirksamen Einwirkdauer des Magnetfelds auf das Mediums. Durch den Entfall der Mechanik ist die Konstruktion des erfindungsgemäßen kernmagnetischen Durchflussmessgeräts wesentlich vereinfacht. Damit sinken der Wartungsaufwand und die Wartungskosten und steigt die Zuverlässigkeit des erfindungsgemäßen kernmagnetischen Durchflussmessgeräts. Im Gegensatz zur Mechanik sind spulenartige Antennen wesentlich kostengünstiger, weshalb bei gleichen Kosten eine höhere Anzahl von Antennen realisierbar ist. Die höhere Anzahl von Antennen ermöglicht die Messung der Magnetisierung des Mediums bei einer höheren Anzahl von unterschiedlichen Einwirkdauern des Magnetfelds auf das Medium, wodurch die Messgenauigkeit verbessert ist.

Bei einer bevorzugten Ausgestaltung des erfindungsgemäßen kernmagnetischen Durchflussmessgeräts ist vorgesehen, dass die Wicklungsdichten von mindestens zwei der spulenartig ausgebildeten Antennen gleich sind. Gleiche Wicklungsdichten vereinfachen die Herstellung der spulenartigen Antennen, wodurch diese kostengünstiger sind. Darüber hinaus weisen die spulenartig ausgebildeten Antennen mit gleichen Wicklungsdichten ähnliche elektrische Eigenschaften auf, wodurch auch die Abstimmung der Messeinrichtung vereinfacht ist.

Es hat sich herausgestellt, dass eine zur Strömungsgeschwindigkeit des Mediums proportionale Länge der Messstrecke bessere Messergebnisse liefert als eine Messstrecke mit einer konstanten Länge für den gesamten Strömungsgeschwindigkeitsbereich des Mediums. Wird zum Beispiel die Strömungsgeschwindigkeit dadurch bestimmt, dass das strömende Medium über eine Messstrecke angeregt wird und anschließend aus den durch die Anregung verursachten abklingenden Messsignalen die Strömungsgeschwindigkeit bestimmt wird, muss die Relaxationszeitkonstante $T_2$ hinreichend groß gegenüber der Verweildauer des Mediums in der Messstrecke sein. Die Relaxationszeitkonstante $T_2$ ist dann hinreichend groß gegenüber der Verweildauer, wenn der Fehler bei der Bestimmung der Strömungsgeschwindigkeit durch das Abklingen der Messsignale aufgrund der Relaxationszeitkonstante $T_2$ für die jeweilige Anwendung tolerabel ist. Folglich ist bei einer gegebenen Relaxationszeitkonstante $T_2$ die Bestimmung von hohen Strömungsgeschwindigkeiten mit einer langen Messstrecke genauer als mit einer kurzen Messstrecke. Daher ist erfindungsgemäß vorgesehen, dass die Messstrecken von mindestens zwei der Antennen unterschiedlich lang sind. Darüber hinaus können die Messergebnisse weiter verbessert werden, wenn die Längen der Messstrecken von mindestens zwei der Antennen in Strömungsrichtung des Mediums zunehmen.

Die Übertragung der Anregungssignale auf das magnetisierte Medium und die Detektion der Messsignale erfolgt durch spulenartige Antennen. Die Übertragung der Anregungssignale auf das magnetisierte Medium kann mit einer ersten Spule erfolgen und die Detektion der Messsignale kann mit einer zweiten Spule erfolgen. In einer weiteren ganz besonders bevorzugten Ausgestaltung des erfindungsgemäßen kernmagnetischen Durchflussmessgeräts ist demgegenüber vorgesehen, dass mindestens eine der Antennen eine einzige Spule zur Übertragung der Anregungssignale auf das magnetisierte Medium und zur Detektion der Signale aufweist. Die Ausführung der Antennen mit nur einer einzigen Spule reduziert auf der einen Seite den Herstellungsaufwand der Antennen signifikant, erhöht aber auf der anderen Seite den Aufwand bei der Messeinrichtung nur geringfügig.

Die einzige Spule mindestens einer der eine einzige Spule aufweisenden Antennen kann eine Zylinderspule sein, wobei das Magnetfeld der Zylinderspule im im Messrohr strömenden Medium zumindest eine zur Messrohrlängsachse parallele Komponente aufweist und die Zylinderspule um das im Messrohr strömende Medium angeordnet ist. Die Anordnung der Zylinderspule um das Messrohr bedeutet, dass die Spulenwicklung um das Messrohr ausgeführt ist. Es ist sogar möglich, die Spulenwicklung auf dem Messrohr auszuführen, so dass die Zylinderspule ein Bestandteil des Messrohrs ist.

Die Antenneneinrichtung kann mindestens eine Antennengruppe aufweisen, wobei die Antennengruppe mindestens zwei eine Zylinderspule als einzige Spule aufweisende Antennen aufweist und die Messstrecken der eine Zylinderspule als einzige Spule aufweisenden Antennen aufeinanderfolgend entlang der Messrohrlängsachse angeordnet sind. Zwei Antennen sind dann aufeinanderfolgend angeordnet, wenn zwischen ihnen keine weitere Antenne angeordnet ist.

Es ist vorteilhaft, wenn mindestens zwei der aufeinanderfolgenden Messstrecken mindestens einer der Antennengruppen durch eine Messabstandsstrecke parallel zur Messrohrlängsachse zur Reduktion der induktiven Kopplung der zwei aufeinanderfolgenden Antennen beabstandet sind. In Abhängigkeit von der Anwendung ist eine gewisse Höhe induktiver Kopplung von zwei aufeinanderfolgenden Antennen tolerierbar, wobei die Tolerierbarkeitsgrenze ein Maß für die Beabstandung der zwei aufeinanderfolgenden Antennen ist.

In einer Weiterbildung der Ausgestaltung des erfindungsgemäßen kernmagnetischen Durchflussmessgeräts kann vorgesehen sein, dass mindestens zwei der durch eine der Messabstandsstrecken beabstandeten Antennen mindestens eine der Antennengruppen eine Verbundantenne mit einer Verbundmessstrecke bilden, die Verbundmessstrecke aus den Messstrecken der Antennen und der Messabstandsstrecken besteht und die Verbundantenne über die Verbundmessstrecke die gleichen Eigenschaften aufweist wie eine der beiden Antennen über ihre jeweilige Messstrecke. Die Antennen einer der Verbundantennen können demnach separat mit ihren jeweiligen Messstrecken betrieben werden, wobei die induktive Kopplung der Antennen tolerierbar ist oder auch als Verbundantenne betrieben werden, wobei die Verbundantenne über die Verbundmessstrecke die gleichen Eigenschaften aufweist wie die Antennen über die jeweiligen Messstrecken.

In einer weiteren ganz besonders bevorzugten Ausgestaltung des erfindungsgemäßen kernmagnetischen Durchflussmessgeräts ist vorgesehen, dass die Antenneneinrichtung mindestens eine angezapfte Spule mit mindestens einer Anzapfung aufweist. Die Anzapfung teilt die angezapfte Spule in zwei Teilspulen auf, und jede der Teilspulen bildet eine der Antennen. Die Antennen sind demnach hier nicht wie zuvor durch einzelne Spulen realisiert, sondern durch eine Spule mit Anzapfungen, wodurch der Herstellungsaufwand reduziert ist.

Die angezapfte Spule kann eine Zylinderspule sein, wobei das Magnetfeld der Zylinderspule im im Messrohr strömenden Medium zumindest eine zur Messrohrlängsachse parallele Komponente aufweist und die Zylinderspule um das im Messrohr strömende Medium angeordnet ist. Die Anordnung der Zylinderspule um das Messrohr bedeutet, dass die Spulenwicklung um das Messrohr ausgeführt ist. Es ist sogar möglich, die Spulenwicklung auf dem Messrohr auszuführen, so dass die Spule ein Bestandteil des Messrohrs ist.

Es hat sich als vorteilhaft für die Qualität der Durchflussmessung herausgestellt, wenn mindestens eine der Antennen mindestens einer der angezapften Spulen eine Kompensationsantenne zur Kompensation des durch die Magnetfelderzeugungseinrichtung im Medium wirkenden Magnetfelds außerhalb mindestens einer der Messstrecken der durch die angezapfte Spule gebildeten Antennen aufweist.

Bei einer anderen bevorzugten Ausgestaltung des erfindungsgemäßen kernmagnetischen Durchflussmessgeräts ist vorgesehen, dass die einzige Spule mindestens einer der Antennen eine Sattelspule ist und das Magnetfeld der Sattelspule im im Messrohr strömenden Medium zumindest eine zur Messrohrlängsachse senkrechte Komponente aufweist.

Während die Zylinderspulen um das Messrohr herum angeordnet werden müssen, werden die Sattelspulen seitlich am Messrohr angeordnet, oder, wie die Bezeichnung schon nahelegt, am Messrohr aufgesattelt. Demnach ist die Anordnung von Sattelspulen am Messrohr weniger aufwändig als die von Zylinderspulen. Ein weiterer, weitaus wesentlicherer Vorteil von Sattelspulen gegenüber Zylinderspulen ist das Merkmal, dass sich das Magnetfeld im Wesentlichen senkrecht zur Messrohrlängsachse und nicht parallel zu dieser erstreckt. Der Vorteil kommt zum Tragen, wenn mindestens zwei der Sattelspulen aufeinanderfolgend entlang der Messrohrlängsachse angeordnet sind. Die induktive Kopplung von zwei aufeinanderfolgend angeordneten Sattelspulen ist weitaus geringer als die von zwei aufeinanderfolgend angeordneten Zylinderspulen.

Eine Weiterbildung der zuvor erläuterten Ausgestaltung eines erfindungsgemäßen kernmagnetischen Durchflussmessgeräts sieht vor, dass die Antenneneinrichtung mindestens ein Antennenpaar aufweist, das Antennenpaar zwei der eine Sattelspule als einzige Spule aufweisenden Antennen aufweist, die beiden eine Sattelspule als einzige Spule aufweisenden Antennen in Bezug auf die Messrohrlängsachse gegenüberliegend sind, die Messstrecken der beiden Antennen deckungsgleich sind, die Richtung des Magnetfelds des Antennenpaars im Medium durch eine Antennenpaarachse beschrieben ist und die Antennenpaarachse zumindest eine zur Messrohrlängsachse senkrechte Komponente aufweist. Die Verwendung eines aus zwei Sattelspulen bestehenden Antennenpaars anstelle einer einzelnen Sattelspule bewirkt eine stärkere Bündelung des Magnetfelds und eine geringere induktive Kopplung mit benachbarten Antennen.

Wenn die Antenneneinrichtung mindestens zwei Antennenpaare aufweist, können die Antennenpaarachsen der beiden Antennenpaare unterschiedlich orientiert sein und können die Messstrecken der Antennenpaare zumindest überlappend sein. Unterschiedliche Orientierungen von Antennenpaarachsen bewirken eine reduzierte induktive Kopplung zwischen den Antennenpaaren.

Bei einer bevorzugten Ausgestaltung des erfindungsgemäßen kernmagnetischen Durchflussmessgeräts ist vorgesehen, dass mindestens eine der Antennen zur Erzeugung eines Magnetfelds ausgebildet ist, die Magnetfeldstärke des Magnetfelds einen Gradienten aufweist und sich das Magnetfeld im Medium zumindest über die Messstrecke der mindestens einen Antenne erstreckt. Der Gradient der Magnetfeldstärke kann ein solcher sein, bei dem die Magnetfeldstärke entlang einer Achse linear zunimmt. Das Magnetfeld kann durch mindestens einen Permanentmagneten und/oder durch mindestens eine bestromte Spule erzeugt werden. Für die Ausgestaltung der mindestens einen Spule gelten die gleichen Ausführungen wie für die Spulen der Antennen.

Das erfindungsgemäße kernmagnetische Durchflussmessgerät, bei dem die Messstrecken von mindestens zwei der Antennen unterschiedlich lang sind, kann mit einem erfindungsgemäßen Verfahren betrieben werden, das zunächst und im Wesentlichen dadurch gekennzeichnet ist, dass durch die Messeinrichtung Anregungssignale erzeugt werden, dass Anregungssignale durch die Antenne auf das sich in der Messstrecke befindende strömende magnetisierte Medium übertragen werden und die von den Anregungssignalen im Medium hervorgerufenen Messsignale von dem sich in der Messstrecke befindenden Medium von der Antenne detektiert werden, dass Anregungssignale durch die mindestens eine weitere Antenne auf das sich in der mindestens einen weiteren Messstrecke befindende strömende magnetisierte Medium übertragen werden und die von den Anregungssignalen im Medium hervorgerufenen Messsignale von dem sich in der mindestens einen weiteren Messstrecke befindenden Medium von der mindestens einen weiteren Antenne detektiert werden, dass abgeleitete Messsignale mit wenigstens reduzierter Beeinflussung durch die Dephasierung gebildet werden, indem die von der Antenne detektierten Messsignale und die von der mindestens einen weiteren Antenne detektieren Messsignale miteinander verknüpft werden, und dass aus den abgeleiteten Messsignalen die Geschwindigkeit des strömenden Mediums bestimmt wird.

Das erfindungsgemäße Verfahren wird im Folgenden ohne Einschränkung der Erfindung an dem Beispiel eines erfindungsgemäßen kernmagnetischen Durchflussmessgeräts näher erläutert, dessen Antenneneinrichtung eine Antenne und nur eine weitere Antenne enthält, wobei die Messstrecke in Strömungsrichtung des Mediums vor der weiteren Messstrecke angeordnet ist. Die Antenne überträgt zum Zeitpunkt $t_{0,1}$ ein Anregungssignal auf das sich in der Messstrecke befindende Medium, und die Amplitude des von der Antenne detektierten Messsignals $y_1$ zum Zeitpunkt $t_1$ ist

$$\hat{y}_1(t_1) = y_{1,1}(t_1)\, y_{1,2}(t_1)$$

$$\text{mit } y_{1,1}(t_1) = 1 - \frac{v(t_1)}{l_1}(t_1 - t_{0,1})$$

$$\text{und } y_{1,2}(t_1) = \sum_{n=1}^{N} M_{1,n} F_n(t_1)\, e^{-\frac{t_1 - t_{0,1}}{T_{2,n}}}$$

Die weitere Antenne überträgt zum Zeitpunkt $t_{0,2}$ ein Anregungssignal auf das sich in der weiteren Messstrecke befindende Medium, und die Amplitude des von der weiteren Antenne detektierten Messsignals $y_2$ zum Zeitpunkt $t_2$ ist

$$\hat{y}_2(t_2) = y_{2,1}(t_2)\, y_{2,2}(t_2)$$

$$\text{mit } y_{2,1}(t_2) = 1 - \frac{v(t_2)}{l_2}(t_2 - t_{0,2})$$

$$\text{und } y_{2,2}(t_2) = \sum_{n=1}^{N} M_{2,n} F_n(t_2)\, e^{-\frac{t_2 - t_{0,2}}{T_{2,n}}}$$

Für den Zeitpunkt $t_1$ muss $0 \le t_1 - t_{0,1} \le l_1/v$ erfüllt sein und für den Zeitpunkt $t_2$ muss $0 \le t_2 - t_{0,2} \le l_2/v$ erfüllt sein. $l_1$ ist die Länge der Messstrecke und $l_2$ die Länge der weiteren Messstrecke, wobei $l_1 \ne l_2$ ist. Der Index n kennzeichnet die einzelnen Phasen des N Phasen enthaltenden Mediums. Bei jeder der Phasen ist $M_{\{1,2\}}$ die Magnetisierung, F der Anteil der Phase am Medium und $T_2$ die bereits erwähnte Relaxationszeitkonstante.

Der jeweils erste Term $y_{\{1,2\},1}$ beschreibt die Abnahme der Amplitude $\hat{y}_{\{1,2\}}$ des jeweiligen Messsignals $y_{\{1,2\}}$ aufgrund des Herausströmens des angeregten Mediums aus der jeweiligen Messstrecke. Der jeweils zweite Term $y_{\{1,2\},2}$ beschreibt die Abnahme der Amplitude des jeweiligen Messsignals durch die Dephasierung, welche durch die Relaxationszeitkonstanten $T_2$ beschrieben ist.

Aus dem Stand der Technik ist die Bestimmung der Strömungsgeschwindigkeit $v(t)$ zu einem Zeitpunkt $t$ mit einer einzigen Antenne bekannt. Die Bestimmung erfordert die Kenntnis der Amplitude $y_{\{1,2\}}(t)$ des Messsignals, der Länge $l_{\{1,2\}}$ der Messstrecke, der Magnetisierungen $M_{\{1,2\}n}$, der Anteile $F_n(t)$ der Phasen am Medium und der Relaxationszeitkonstanten $T_{2,n}$.

Gemäß dem erfindungsgemäßen Verfahren wird das abgeleitete Messsignal im Beispiel durch Verknüpfung der Amplitude $\hat{y}_1(t_1)$ des von der Antenne detektierten Messsignals und der Amplitude $\hat{y}_2(t_2)$ des von der weiteren Antenne detektierten Messsignals gebildet.

Die Magnetisierung $M_{\{1,2\},n}$ der Phasen des Mediums nimmt in Strömungsrichtung des Mediums über die Magnetfeldstrecke bis zur Sättigungsmagnetisierung zu. Falls das Medium in der Messstrecke und in der weiteren Messstrecke nicht bis zur Sättigung magnetisiert ist, kann eine hinreichend gleiche Magnetisierung des Mediums in der Messstrecke und in der weiteren Messstrecke durch eine Abstandsstrecke mit der Länge $a$ parallel zur Messrohrlängsachse zwischen der Messstrecke und der weiteren Messstrecke eingestellt werden. Dabei sollte die Abstandsstrecke derart bemessen sein, dass das von der Antenne angeregte Medium erst dann die weitere Messstrecke erreicht, wenn das von der weiteren Antenne angeregte Medium schon vollständig aus der weiteren Messstrecke herausgeströmt ist, also wenn die Bedingung $a \ge l_2$ erfüllt ist. Andernfalls verfälscht das von der Antenne angeregte Medium die von der weiteren Antenne detektierten Messsignale. Darüber hinaus sollte die induktive Kopplung zwischen der Antenne und der weiteren Antenne hinreichend gering sein. Unter Berücksichtigung der voranstehenden Ausführungen sind in den zweiten Termen $y_{\{1,2\},2}$ die Magnetisierungen zumindest hinreichend gleich, es ist demnach $M_{1,n} \approx M_{2,n}$.

Die Messzeitpunkte $t_{\{1,2\}}$ können derart gewählt werden, dass im Zeitintervall zwischen dem Messzeitpunkt $t_1$ und dem Messzeitpunkt $t_2$ die Veränderung der Strömungsgeschwindigkeit hinreichend gering ist, folglich $v(t_1) \approx v(t_2)$ ist, und die Veränderung der Anteile der Phasen des Mediums hinreichend gering ist, demnach $F_n(t_1) \approx F_n(t_2)$ ist.

Darüber hinaus können die Anregungszeitpunkte $t_{0,\{1,2\}}$ derart gewählt werden, dass zumindest $t_1 - t_{0,1} \approx t_2 - t_{0,2}$ gilt, wodurch unter Berücksichtigung der voranstehenden Ausführungen die zweiten Terme $y_{\{1,2\},2}$ insgesamt hinreichend gleich sind. Die Beeinflussung des abgeleiteten Messsignals durch die Dephasierung ist folglich zumindest reduziert. Was in den vorausgehenden Ausführungen hinreichend ist, ist durch die Anforderungen der jeweiligen Anwendung an das kernmagnetische Durchflussmessgerät bestimmt.

Die abgeleiteten Messsignale können Quotienten sein, wobei jeder der Quotienten aus dem von einer der Antennen detektierten Messsignal und aus dem von einer der übrigen Antennen detektierten Messsignal gebildet wird und wobei die Messstrecke der Antenne und die Messstrecke der übrigen Antenne unterschiedlich lang sind. Auf das Beispiel übertragen wird der Quotient aus der Amplitude $\hat{y}_1(t_1)$ des von der Antenne detektierten Messsignals und der Amplitude $\hat{y}_2(t_2)$ des von der weiteren Antenne detektierten Messsignals gebildet:

$$\hat{y}'(t_1, t_2) = \frac{\hat{y}_1(t_1)}{\hat{y}_2(t_2)} \approx \frac{y_{1,1}(t_1)}{y_{2,1}(t_2)} = \frac{1 - \dfrac{v(t_1)}{l_1}(t_1 - t_{0,1})}{1 + \dfrac{v(t_2)}{l_2}(t_2 - t_{0,2})}$$

Vorzugsweise werden durch die Antenne und durch mindestens eine der weiteren Antennen die Anregungssignale zur gleichen Zeit auf das Medium übertragen. Auf das Beispiel angewendet werden die Anregungszeitpunkte $t_{0,\{1,2\}}$ gleich gewählt, wodurch auch zumindest $t_1 \approx t_2$ ist. Damit ist das abgeleitete Messsignal

$$\hat{y}'(t_1) = \frac{\hat{y}_1(t_1)}{\hat{y}_2(t_1)} = \frac{1 - \dfrac{v(t_1)}{l_1}(t_1 - t_{0,1})}{1 - \dfrac{v(t_1)}{l_2}(t_1 - t_{0,1})}$$

Aus diesem kann die Strömungsgeschwindigkeit auf einfache Weise berechnet werden:

$$v(t_1) = \frac{l_1\, l_2\, (\hat{y}'(t_1) - 1)}{(\hat{y}'(t_1)l_1 - l_2)(t_1 - t_{0,1})}$$

Für die erfindungsgemäße Bestimmung der Strömungsgeschwindigkeit des Mediums im Messrohr zu einem beliebigen Zeitpunkt ist demnach lediglich die Kenntnis der Längen der Messstrecken, der Amplituden der Messsignale und des Anregungszeitpunktes erforderlich. Demnach ist die Kenntnis der Relaxationszeitkonstanten $T_{2,n}$ nicht erforderlich. Die Fähigkeit, die Strömungsgeschwindigkeit des Mediums ohne Kenntnis der Relaxationszeitkonstanten $T_{2,n}$ bestimmen zu können, kann auch als Selbstkalibrierung bezeichnet werden, da eine Kalibrierung des erfindungsgemäßen kernmagnetischen Durchflussmessgeräts mit Medien, die unterschiedliche bekannten Relaxationszeitkonstanten $T_{2,n}$ aufweisen, nicht mehr erforderlich ist.

Da die Strömungsgeschwindigkeit des Mediums jetzt bekannt ist, kann die Wirkung der Strömungsgeschwindigkeit auf das von der Antenne detektierte Messsignal eliminiert werden, wodurch sich die Amplitude eines kompensierten Messsignals ergibt:

$$\hat{y}'_1(t_1) = \frac{\hat{y}_1(t_1)}{y_{1,1}(t_1)} = y_{1,2}(t_1) = \frac{\hat{y}_1(t_1)}{1 - \dfrac{v(t_1)}{l_1}(t_1 - t_{0,1})} = \sum_{n=1}^{N} M_{1,n}\, F_n(t_1)\, e^{-\frac{t_1 - t_{0,1}}{T_{2,n}}}$$

Die Amplitude des kompensierten Messsignals entspricht demnach der Amplitude eines Messsignals, das sich ergibt, wenn das Medium im Messrohr steht. Folglich können aus den Amplituden des kompensierten Messsignals die Relaxationszeitkonstanten $T_{2,n}$ bestimmt werden. Aus den Relaxationszeitkonstanten $T_{2,n}$ können dann mit diesen korrelierte Eigenschaften der Phasen des Mediums wie zum Beispiel die Viskositäten der Phasen bestimmt werden.

Im Einzelnen gibt es nun verschiedene Möglichkeiten, das erfindungsgemäße kernmagnetische Durchflussmessgerät auszugestalten und weiterzubilden. Dazu wird verwiesen sowohl auf die dem Patentanspruch 1 nachgeordneten Patentansprüche als auch auf die Beschreibung bevorzugter Ausführungsbeispiele in Verbindung mit der Zeichnung. In der Zeichnung zeigen

Fig. 1      ein erstes Ausführungsbeispiel eines erfindungsgemäßen kernmagnetischen Durchflussmessgeräts mit drei Zylinderspulen,

Fig. 2      ein zweites Ausführungsbeispiel eines erfindungsgemäßen kernmagnetischen Durchflussmessgeräts mit einer einzigen angezapften Zylinderspule und

Fig. 3a, 3b    eine dritte Ausführungsbeispiel eines erfindungsgemäßen kernmagnetischen Durchflussmessgeräts mit einer Zylinderspule und mit zwei Sattelspulen.

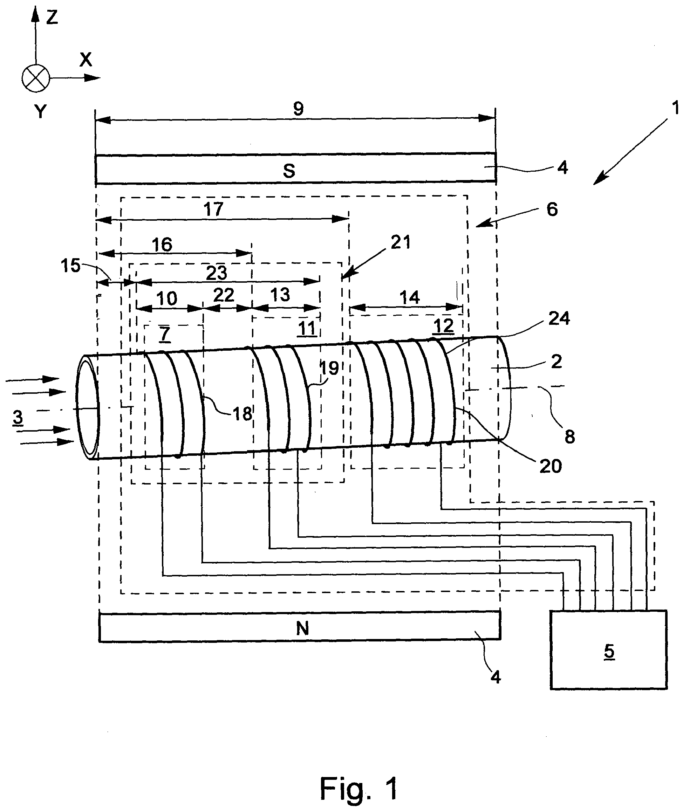

In Fig. 1 sind die wesentlichen Elemente eines ersten Ausführungsbeispiels eines erfindungsgemäßen kernmagnetischen Durchflussmessgeräts 1 schematisch dargestellt, das zunächst ein Messrohr 2 aufweist, welches von einem Medium 3 durchströmt ist. Das kernmagnetische Durchflussmessgerät 1 ist zur Bestimmung des Durchflusses des Mediums 3 durch das Messrohr 2 ausgebildet, wobei das Medium 3 auch mehrere Phasen enthalten kann. Zur Bestimmung des Durchflusses des Mediums 3 durch das Messrohr 2 weist das kernmagnetische Durchflussmessgerät 1 eine Magnetfelderzeugungseinrichtung 4, eine Messeinrichtung 5 und eine Antenneneinrichtung 6 mit einer Antenne 7 auf.

Die Messrohrlängsachse 8 des Messrohrs 2 ist per Definition parallel zur x-Achse eines kartesischen Koordinatensystems ausgerichtet, wodurch das Medium 3 parallel zur x-Achse und per Definition in positiver x-Richtung strömt. Die Magnetfelderzeugungseinrichtung 4 erzeugt ein Magnetfeld, welches das strömende Medium 3 über eine parallel zur x-Achse ausgerichtete Magnetfeldstrecke 9 per Definition in positiver z-Richtung des Koordinatensystems durchsetzt. Die Richtung des strömenden Mediums 3 und die Richtung des Magnetfelds sind demnach senkrecht zueinander orientiert.

Die Messeinrichtung 5 ist zur Erzeugung von das magnetisierte Medium 3 anregenden Anregungssignalen und zur Messung der von den Anregungssignalen im magnetisierten Medium 3 hervorgerufenen Messsignale ausgebildet.

Die Antenne 7 der Antenneneinrichtung 6 ist über eine parallel zur x-Achse ausgerichtete und in der Magnetfeldstrecke 9 liegende Messstrecke 10 zur Übertragung sowohl der Anregungssignale auf das magnetisierte Medium 3 als auch zur Detektion der Messsignale ausgebildet. Das erfindungsgemäße kernmagnetische Durchflussmessgerät 1 weist neben der Antenne 7 mit der Messstrecke 10 eine erste weitere Antenne 11 und eine zweite weitere Antenne 12 auf. Die erste weitere Antenne 11 ist über eine parallel zur x-Achse ausgerichtete, in der Magnetfeldstrecke 9 liegende erste weitere Messstrecke 13 und die zweite weitere Antenne 12 ist über eine parallel zur x-Achse ausgerichtete, in der Magnetfeldstrecke 9 liegende zweite weitere Messstrecke 14 zur Übertragung der Anregungssignale auf das magnetisierte Medium 3 und zur Detektion der Messsignale ausgebildet.

Die Antenneneinrichtung 6 ist zur Übertragung der Anregungssignale von der Messeinrichtung 5 zur Antenne 7, zur ersten weiteren Antenne 11 und zur zweiten weiteren Antenne 12 und zur Übertragung der Messsignale von der Antenne 7, von der ersten weiteren Antenne 11 und von der zweiten weiteren Antenne 12 zur Messeinrichtung 5 ausgebildet.

Die Messeinrichtung 5 ist zur Erzeugung und die Antenneneinrichtung 6 zur Übertragung der Anregungssignale über jede beliebige der Antennen 7, 11, 12, unabhängig von den übrigen Antennen 7, 11, 12, auf das magnetisierte Medium 3, auch über mehr als eine der Antennen 7, 11, 12 gleichzeitig ausgebildet. Darüber hinaus ist die Messeinrichtung 5 zur Messung und die Antenneneinrichtung 6 zur Detektion der Messsignale des angeregten Mediums 3 mit einer beliebigen der Antennen 7, 11, 12, unabhängig von den übrigen Antennen 7, 11, 12 oder auch mit mehr als einer der Antennen 7, 11, 12 gleichzeitig, ausgebildet. Insbesondere ist es auch möglich, über eine oder mehrere beliebige der Antennen 7, 11, 12 ein Anregungssignal auf das Medium 3 zu übertragen und mit einer oder mehreren beliebigen anderen der Antennen 7, 11, 12 das von diesem Anregungssignal im Medium 3 hervorgerufene Messsignal zu detektieren. Vorzugsweise sind die Antennen 7, 11, 12, mit denen ein Messsignal detektiert wird, entlang der x-Achse in Bezug auf die positive x-Richtung auf gleicher Höhe oder hinter den Antennen 7, 11, 12 angeordnet, über welche das das Messsignal hervorrufende Anregungssignal auf das Medium 3 übertragen wird.

Die Länge der Messstrecke 10 der Antenne 7 ist geringer als die Länge der ersten weiteren Messstrecke 13 der ersten weiteren Antenne 11 und die Länge der ersten weiteren Messstrecke 13 ist geringer als die Länge der zweiten weiteren Messstrecke 14 der zweiten weiteren Antenne 12. Entlang der x-Achse in Bezug auf die positive x-Richtung ist die erste weitere Antenne 11 hinter der Antenne 7 angeordnet und ist die zweite weitere Antenne 12 hinter der ersten weiteren Antenne 11 angeordnet. Das im Messrohr 2 strömende Medium 3 legt vom Anfang der Magnetfeldstrecke 9 bis zum Anfang der Messstrecke 10 eine erste Einlaufstrecke 15, vom Anfang der Magnetfeldstrecke 9 bis zum Anfang der ersten weiteren Messstrecke 13 eine erste weitere Einlaufstrecke 16 und vom Anfang der Magnetfeldstrecke 9 bis zum Anfang der zweiten weiteren Messstrecke 14 eine zweite weitere Einlaufstrecke 17 parallel zur x-Achse zurück. Entsprechend der Anordnung der Antennen 7, 11, 12 ist die Länge der Einlaufstrecke 15 geringer als die Länge der ersten weiteren Einlaufstrecke 16 und ist die Länge der ersten weiteren Einlaufstrecke 16 geringer als die Länge der zweiten weiteren Einlaufstrecke 17. Den Längen der Einlaufstrecken 15, 16, 17 entsprechen die jeweilige Einwirkdauer des von der Magnetfelderzeugungseinrichtung 4 erzeugten Magnetfelds auf das strömende Medium 3. Allgemein sind Messstrecken durch ihre Länge parallel zur x-Achse und der Position auf der x-Achse eindeutig bestimmt. Demnach sind die Messstrecken 10, 13, 14 verschieden.

Die Antenne 7 weist eine Zylinderspule 18, die erste weitere Antenne 11 eine erste weitere Zylinderspule 19 und die zweite weitere Antenne 12 eine zweite weitere Zylinderspule 20 als einzige Spule zur Übertragung der Anregungssignale auf das magnetisierte Medium 3 und zur Detektion der Messsignale auf. Die Zylinderspulen 18, 19, 20 sind derart um das Messrohr 2 angeordnet, dass das Magnetfeld der bestromten Zylinderspulen 18, 19, 20 zumindest eine zur x-Achse parallele Komponente im strömenden Medium 3 aufweist.

Das durch das Messrohr 2 strömende Medium 3 wird durch das in positiver z-Richtung wirkende Magnetfeld der Magnetfelderzeugungseinrichtung 4 magnetisiert. Dabei präzessieren die Atomkerne mit einem magnetischen Moment ohne Phasenbezug zueinander um die z-Achse. Ein von der Messeinrichtung 5 erzeugtes Anregungssignal, dessen Frequenzspektrum die Larmorfrequenz umfasst, wird von der Antenneneinrichtung 6 zu mindestens einer der Antennen 7, 11, 12 übertragen. Dieses Anregungssignal bewirkt in der ausgewählten Zylinderspule 18, 19, 20 ein Wechselmagnetfeld mit einer Komponente in x-Richtung, wodurch auf die präzessierenden Atomkerne des Mediums 3 ein Drehmoment ausgeübt wird, welches die präzessierenden Atomkerne in die x-y-Ebene dreht und eine Gleichphasigkeit der Präzessionen der Atomkerne bewirkt. Das auf diese Weise angeregte Medium 3 induziert in mindestens einer der Zylinderspulen 18, 19, 20 ein Messsignal, welches von der Antenneneinrichtung 6 zur Messeinrichtung 5 übertragen wird.

Die Antenne 7 und die hinter der Antenne 7 angeordnete erste weitere Antenne 11 bilden eine Antennengruppe 21. Die Messstrecke 10 der Antenne 7 und die erste weitere Messstrecke 13 der ersten weiteren Antenne 11 sind durch eine Messabstandsstrecke 22 parallel zur x-Achse zur Reduktion der induktiven Kopplung der Zylinderspule 18 und der ersten weiteren Zylinderspule 19 beabstandet. Daneben bildet die Antennengruppe 21 eine Verbundantenne mit einer Verbundmessstrecke 23. Die Verbundmessstrecke 23 setzt sich aus der Messstrecke 10 der Antenne 7, aus der Messabstandsstrecke 22 und der ersten weiteren Messstrecke 13 zusammen. Die Verbundantenne 23 weist über die Verbundmessstrecke 23 die gleichen Eigenschaften in Bezug auf das Medium 3 auf wie die Antenne 7 über die Messstrecke 10 und die erste weitere Antenne 11 über die erste weitere Messstrecke 13.

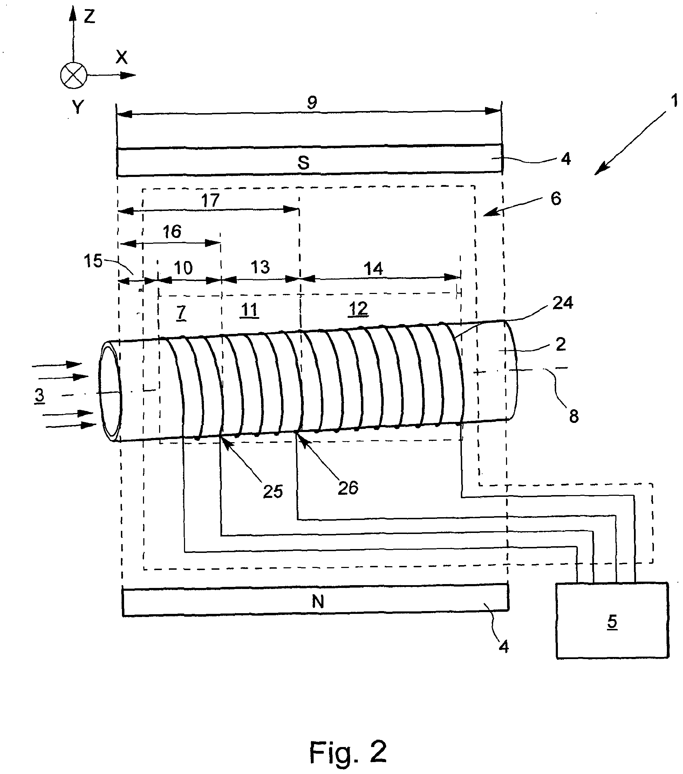

In Fig. 2 sind die wesentlichen Elemente eines zweiten Ausführungsbeispiels eines erfindungsgemäßen kernmagnetischen Durchflussmessgeräts 1 schematisch dargestellt. Im Gegensatz zu dem in Fig. 1 dargestellten Ausführungsbeispiel enthält die Antenneneinrichtung 6 nur eine einzige Spule 24 zur Übertragung der Anregungssignale auf das magnetisierte Medium 3 und zur Detektion der Messsignale. Die einzige Spule 24 ist eine als Zylinderspule ausgebildete angezapfte Spule mit einer ersten Anzapfung 25 und einer zweiten Anzapfung 26. Die angezapfte Spule 24 ist um das im Messrohr 2 strömende Medium 3 angeordnet und das Magnetfeld weist im im Messrohr 2 strömenden Medium 3 zumindest eine zur x-Achse parallele Komponente auf. Die Anzapfung 24 und die Anzapfung 25 teilen die angezapfte Spule 24 in eine erste Teilspule, eine zweite Teilspule und in eine dritte Teilspule auf. Die erste Teilspule bildet die Antenne 7 mit der Messstrecke 10, die zweite Teilspule bildet die erste weitere Antenne 11 mit der ersten weiteren Messstrecke 13 und die dritte Teilspule bildet die zweite weitere Antenne 12 mit der zweiten weiteren Messstrecke 14. Die übrigen Ausführungen zum in Fig. 1 dargestellten ersten Ausführungsbeispiel treffen auch für das Ausführungsbeispiel in Fig. 2 zu.

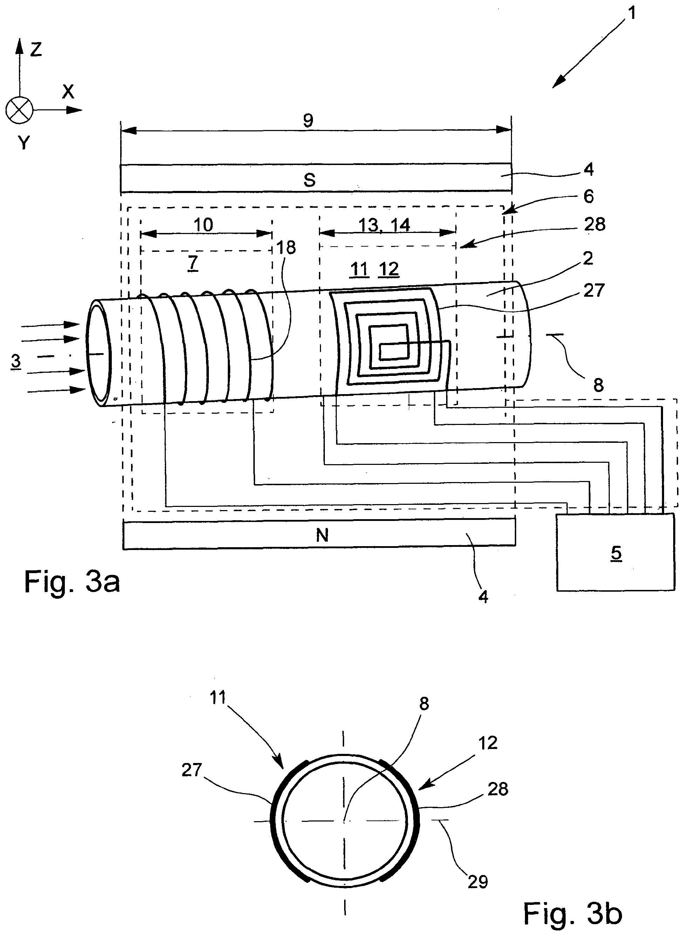

In Fig. 3a und Fig. 3b sind die wesentlichen Elemente eines dritten Ausführungsbeispiels eines erfindungsgemäßen kernmagnetischen Durchflussmessgeräts 1 schematisch dargestellt. Die Antenneneinrichtung 6 weist neben der aus dem ersten Ausführungsbeispiel bekannten Zylinderspule 18, welche die Antenne 7 mit der Messstrecke 10 bildet, auch eine erste Sattelspule 27 und eine zweite Sattelspule 28 auf. Die erste Sattelspule 27 bildet über die erste weitere Messstrecke 13 die erste weitere Antenne 11 und die zweite weitere Sattelspule 28 bildet über die zweite weitere Messstrecke 14 die zweite weitere Antenne 12.

Das Magnetfeld jeder der Sattelspulen 27, 28 weist im im Messrohr 2 strömenden Medium 3 zumindest eine zur y-Achse parallele Komponente auf. Im Gegensatz dazu weist das Magnetfeld der Zylinderspule 18 im im Messrohr 2 strömenden Medium 3 zumindest eine zur x-Achse parallele Komponente auf. Durch die verschiedenen Richtungen des Magnetfelds der Zylinderspule 18 auf der einen Seite und der Magnetfelder der Sattelspulen 27, 28 auf der anderen Seite ist die induktive Kopplung zwischen der Zylinderspule 18 und den Sattelspulen 27, 28 geringer als wenn die Sattelspulen 27, 28 durch eine Zylinderspule mit zumindest einer zur x-Achse parallelen Komponente des Magnetfelds ersetzt würden. Durch die geringere induktive Kopplung ist die Qualität der Messdaten verbessert.

Die erste weitere Antenne 11 und die zweite weitere Antenne 12 sind in Bezug auf die x-Achse gegenüberliegend um das Messrohr 2 angeordnet, und zwar derart, dass die erste weitere Messstrecke 13 und die zweite weitere Messstrecke 14 deckungsgleich sind. Die Richtung des gemeinsamen Magnetfelds der ersten Sattelspule 27 und der zweiten Sattelspule 28 im strömenden Medium 3 ist durch eine Antennenpaarachse 29 beschrieben, welche mit der y-Achse zusammenfällt. Die übrigen Ausführungen zum in Fig. 1 dargestellten ersten Ausführungsbeispiel treffen auch für dieses Ausführungsbeispiel zu.

Bezugszeichen:

1    kernmagnetisches Durchflussmessgerät
2    Messrohr
3    Medium
4    Magnetfelderzeugungseinrichtung
5    Messeinrichtung
6    Antenneneinrichtung
7    Antenne
8    Messrohrlängsachse
9    Magnetfeldstrecke
10   Messstrecke der Antenne
11   erste weitere Antenne
12   zweite weitere Antenne
13   erste weitere Messstrecke
14   zweite weitere Messstrecke
15   Einlaufstrecke
16   erste weitere Einlaufstrecke
17   zweite weitere Einlaufstrecke
18   erste Zylinderspule
19   zweite Zylinderspule
20   dritte Zylinderspule
21   Antennengruppe
22   Messabstandsstrecke
23   Verbundmessstrecke
24   angezapfte Spule
25   erste Anzapfung
26   zweite Anzapfung
27   erste Sattelspule
28   zweite Sattelspule
29   Antennenpaarachse

**Patentansprüche**

1. Kernmagnetisches Durchflussmessgerät (1) zur Bestimmung des Durchflusses eines durch ein Messrohr (2) strömenden Mediums mit einer Magnetfelderzeugungseinrichtung (4), einer Messeinrichtung (5) und einer Antenneneinrichtung (6) mit einer Antenne (7),

   wobei die Magnetfelderzeugungseinrichtung (4) über eine parallel zur Messrohrlängsachse (8) ausgerichtete Magnetfeldstrecke (9) das strömende Medium (3) mit einem zumindest eine zur Messrohrlängsachse (8) senkrechte Komponente aufweisenden Magnetfeld zur Magnetisierung des Mediums (3) durchsetzt,
   wobei die Messeinrichtung (5) zur Erzeugung von das magnetisierte Medium (3) anregenden Anregungssignalen und zur Messung der von den Anregungssignalen im magnetisierten Medium (3) hervorgerufenen Messsignale ausgebildet ist,
   wobei die Antenne (7) spulenartig ausgebildet ist und über eine parallel zur Messrohrlängsachse (8) ausgerichtete und in der Magnetfeldstrecke (9) liegende Messstrecke (10) zur Übertragung der Anregungssignale auf das magnetisierte Medium (3) und zur Detektion der Messsignale ausgebildet ist,
   wobei die Antenneneinrichtung (6) mindestens eine weitere Antenne (11, 12) aufweist,
   wobei die weitere Antenne (11, 12) spulenartig ausgebildet ist und über eine weitere parallel zur Messrohrlängsachse (8) ausgerichtete und in der Magnetfeldstrecke (9) liegende Messstrecke (13, 14) zur Übertragung der Anregungssignale auf das magnetisierte Medium (3) und zur Detektion der Messsignale ausgebildet ist und
   wobei die Messstrecke (10) und die weitere Messstrecke (13, 14) verschieden sind,
   **dadurch gekennzeichnet,**
   **dass** die Messstrecken (10, 13, 14) von mindestens zwei der Antennen (7, 11, 12) unterschiedlich lang sind.

2. Kernmagnetisches Durchflussmessgerät (1) nach Anspruch 1, **dadurch gekennzeichnet, dass** die Wicklungsdichten von mindestens zwei der spulenartig ausgebildeten Antennen (7, 11, 12) gleich sind.

3. Kernmagnetisches Durchflussmessgerät (1) nach Anspruch 1 oder 2, **dadurch gekennzeichnet, dass** die Längen der Messstrecken (10, 13 14) von mindestens zwei der Antennen (7, 11, 12) in Strömungsrichtung des Mediums (3) zunehmen.

4. Kernmagnetisches Durchflussmessgerät (1) nach einem der Ansprüche 1 bis 3, **dadurch gekennzeichnet, dass** mindestens eine der Antennen (7, 11, 12) eine einzige Spule zur Übertragung der Anregungssignale auf das magnetisierte Medium (3) und zur Detektion der Messsignale aufweist.

5. Kernmagnetisches Durchflussmessgerät (1) nach Anspruch 4, **dadurch gekennzeichnet, dass** die einzige Spule mindestens einer der eine einzige Spule aufweisenden Antennen (7, 11, 12) eine Zylinderspule (18, 19, 20) ist, das Magnetfeld der Zylinderspule (18, 19, 20) im im Messrohr (2) strömenden Medium (3) zumindest eine zur Messrohrlängsachse (8) parallele Komponente aufweist und die Zylinderspule (18, 19, 20) um das im Messrohr (2) strömende Medium (3) angeordnet ist.

6. Kernmagnetisches Durchflussmessgerät (1) nach Anspruch 5, **dadurch gekennzeichnet, dass** die Antenneneinrichtung (6) mindestens eine Antennengruppe (21) aufweist, die Antennengruppe (21) mindestens zwei eine Zylinderspule (18, 19) als einzige Spule aufweisende Antennen (7, 11) aufweist und die Messstrecken (10, 13) der eine Zylinderspule (18, 19) als einzige Spule aufweisenden Antennen (7, 11) aufeinanderfolgend entlang der Messrohrlängsachse (8) angeordnet sind.

7. Kernmagnetisches Durchflussmessgerät (1) nach Anspruch 6, **dadurch gekennzeichnet, dass** mindestens zwei der aufeinanderfolgenden Messstrecken (10, 13) mindestens einer der Antennengruppen (21) durch eine Messabstandsstrecke (22) parallel zur Messrohrlängsachse (8) zur Reduktion der induktiven Kopplung der zwei aufeinanderfolgenden Antennen (7, 11) beabstandet sind.

8. Kernmagnetisches Durchflussmessgerät (1) nach Anspruch 7, **dadurch gekennzeichnet, dass** mindestens zwei der durch eine der Messabstandsstrecken (22) beabstandeten Antennen (7, 11) mindestens einer der Antennengruppen (21) eine Verbundantenne mit einer Verbundmessstrecke (23) bilden, die Verbundmessstrecke (23) aus den Messstrecken (10, 13) der Antennen (7, 11) und der Messabstandsstrecken (22) besteht und die Verbundantenne über die Verbundmessstrecke (23) die gleichen Eigenschaften aufweist wie eine der beiden Antennen (7, 11) über ihre jeweilige Messstrecke (10, 13).

9. Kernmagnetisches Durchflussmessgerät (1) nach einem der Ansprüche 1 bis 8, **dadurch gekennzeichnet, dass** die Antenneneinrichtung (6) mindestens eine angezapfte Spule (24) mit mindestens einer Anzapfung (25, 26) aufweist, die Anzapfung (25, 26) die angezapfte Spule (24) in zwei Teilspulen aufteilt und jede der Teilspulen eine der Antenne (7, 11, 12) bildet.

10. Kernmagnetisches Durchflussmessgerät (1) nach Anspruch 9, **dadurch gekennzeichnet, dass** mindestens eine der angezapften Spulen (24) eine Zylinderspule ist, das Magnetfeld der Zylinderspule im im Messrohr (2) strömenden Medium (3) zumindest eine zur Messrohrlängsachse (8) parallele Komponente aufweist und die Zylinderspule um das im Messrohr (2) strömende Medium (3) angeordnet ist.

11. Kernmagnetisches Durchflussmessgerät (1) nach Anspruch 9 oder 10, **dadurch gekennzeichnet, dass** mindestens eine der Antennen (7, 11, 12) mindestens einer der angezapften Spulen (24) eine Kompensationsantenne zur Kompensation des durch die Magnetfelderzeugungseinrichtung (4) im Medium (3) wirkenden Magnetfelds außerhalb mindestens einer der Messstrecken (10, 13, 14) der durch die angezapfte Spule (24) gebildeten Antennen (7, 11, 12) aufweist.

12. Kernmagnetisches Durchflussmessgerät (1) nach einem der Ansprüche 4 bis 11, **dadurch gekennzeichnet, dass** die einzige Spule mindestens einer der Antennen (11, 12) eine Sattelspule (27, 28) ist und das Magnetfeld der Sattelspule (27, 28) im im Messrohr (2) strömenden Medium (3) zumindest eine zur Messrohrlängsachse (8) senkrechte Komponente aufweist.

13. Kernmagnetisches Durchflussmessgerät (1) nach Anspruch 12, **dadurch gekennzeichnet, dass** die Antenneneinrichtung (6) mindestens ein Antennenpaar aufweist, das Antennenpaar zwei der eine Sattelspule (27, 28) als einzige Spule aufweisenden Antennen (11, 12) aufweist, die beiden eine Sattelspule (27, 28) als einzige Spule aufweisenden Antennen (11, 12) in Bezug auf die Messrohrlängsachse (8) gegenüberliegend sind, die Messstrecken (13, 14) der beiden Antennen (11, 12) deckungsgleich sind, die Richtung des Magnetfelds des Antennenpaars im Medium (3) durch eine Antennenpaarachse (29) beschrieben ist und die Antennenpaarachse (29) zumindest eine zur Messrohrlängsachse (8) senkrechte Komponente aufweist.

**14.** Kernmagnetisches Durchflussmessgerät (1) nach Anspruch 13, **dadurch gekennzeichnet, dass** die Antenneneinrichtung (6) mindestens zwei Antennenpaare aufweist, die Antennenpaarachsen (29) der beiden Antennenpaare unterschiedlich orientiert sind und die Messstrecken (13, 14) der Antennenpaare zumindest überlappend sind.

**15.** Kernmagnetisches Durchflussmessgerät (1) nach einem der Ansprüche 1 bis 14, **dadurch gekennzeichnet, dass** mindestens eine der Antennen (7, 11, 12) zur Erzeugung eines Magnetfelds ausgebildet ist, die Magnetfeldstärke des Magnetfelds einen Gradienten aufweist und sich das Magnetfeld im Medium zumindest über die Messstrecke (10, 13, 14) der mindestens einen Antenne (7, 11, 12) erstreckt.

**16.** Verfahren zum Betreiben eines kernmagnetischen Durchflussmessgeräts (1) nach Anspruch 1,

**dadurch gekennzeichnet,**
**dass** durch die Messeinrichtung (5) Anregungssignale erzeugt werden,
**dass** Anregungssignale durch die Antenne (7) auf das sich in der Messstrecke (10) befindende strömende magnetisierte Medium (3) übertragen werden und die von den Anregungssignalen im Medium (3) hervorgerufenen Messsignale von dem sich in der Messstrecke (10) befindenden Medium (3) von der Antenne (7) detektiert werden,
**dass** Anregungssignale durch die mindestens eine weitere Antenne (11, 12) auf das sich in der mindestens einen weiteren Messstrecke (13, 14) befindende strömende magnetisierte Medium (3) übertragen werden und die von den Anregungssignalen im Medium (3) hervorgerufenen Messsignale von dem sich in der mindestens einen weiteren Messstrecke (13, 14) befindenden Medium (3) von der mindestens einen weiteren Antenne (11, 12) detektiert werden,
**dass** abgeleitete Messsignale mit wenigstens reduzierter Beeinflussung durch die Dephasierung gebildet werden, indem die von der Antenne (7) detektierten Messsignale und die von der mindestens einen weiteren Antenne (11, 12) detektieren Messsignale miteinander verknüpft werden,
**dass** die Messstrecke (10, 13, 14) der Antenne und die Messstrecke (10, 13, 14) der übrigen Antenne (7, 11, 12) unterschiedlich lang sind, und
**dass** aus den abgeleiteten Messsignalen die Geschwindigkeit des strömenden Mediums (3) bestimmt wird.

**17.** Verfahren nach Anspruch 16, **dadurch gekennzeichnet, dass** die abgeleiteten Messsignale Quotienten sind, dass jeder der Quotienten aus dem von einer der Antennen (7, 11, 12) detektierten Messsignal und aus dem von einer der übrigen Antennen (7, 11, 12) detektierten Messsignal gebildet wird.

**18.** Verfahren nach Anspruch 16 oder 17, **dadurch gekennzeichnet, dass** durch die Antenne (7, 11, 12) und durch mindestens eine der weiteren Antennen (7, 11, 12) die Anregungssignale zur gleichen Zeit auf das Medium (3) übertragen werden.

**Claims**

**1.** Nuclear magnetic flowmeter (1) for determining the flow of a medium flowing through a measuring tube (2) having a magnetic field generator (4), a measuring unit (5) and an antennae unit (6) with an antenna (7),

wherein the magnetic field generator (4) permeates the flowing medium (3) with a magnetic field having at least a component perpendicular to a longitudinal axis (8) of the measuring tube over a magnetic field path (9) aligned parallel to the longitudinal axis (8) of the measuring tube for magnetizing the medium,
wherein the measuring unit (5) is designed to generate excitation signals exciting the magnetized medium (3) and to measure measuring signals caused by the excitation signals in the magnetized medium (3),
wherein the antenna (7) is designed as a coil and is designed for transmitting the excitation signals to the magnetized medium (3) and for detecting the measuring signal over a measuring section (10) aligned parallel to the longitudinal axis (8) of the measuring tube and located in the magnetic field path (9),
wherein the antennae unit (6) has at least one further antenna (11, 12), wherein the further antenna (11, 12) is designed as a coil and is designed for transmitting the excitation signals to the magnetized medium (3) and for detecting the measuring signals over a further measuring section (13, 14) aligned parallel to the longitudinal axis (8) of the measuring tube and located in the magnetic field path (9), and
wherein the measuring section (10) and the further measuring section (13, 14) are different,

**characterized in**
**that** the measuring sections (10, 13, 14) of at least two of the antennae (7, 11, 12) have different lengths.

2. Nuclear magnetic flowmeter (1) according to claim 1, **characterized in that** winding densities of at least two of the antennae (7, 11, 12) designed as coils are the same.

3. Nuclear magnetic flowmeter (1) according to claim 1 or 2, **characterized in that** the lengths of the measuring sections (10, 13, 14) of at least two of the antennae (7, 11, 12) increase in a direction of flow of the medium (3).

4. Nuclear magnetic flowmeter (1) according to any one of claims 1 to 3, **characterized in that** at least one of the antennae (7, 11, 12) has a sole coil for transmitting the excitation signals to the magnetized medium (3) and for detecting the measuring signal.

5. Nuclear magnetic flowmeter (1) according to claim 4, **characterized in that** the single coil of at least one of the antennae (7, 11, 12) having a single coil is a solenoid (18, 19, 20), the magnetic field of the solenoid (18, 19, 20) in the medium (3) flowing in the measuring tube (2) has at least one component parallel to the longitudinal axis (8) of the measuring tube and the solenoid (18, 19, 20) is arranged around the medium (3) flowing in the measuring tube (2).

6. Nuclear magnetic flowmeter (1) according to claim 5, **characterized in that** the antennae unit (6) has at least one antennae group (21), the antennae group (21) has at least two antennae (7, 11) each with a solenoid (18, 19) as sole coil and the measuring sections (10, 13) of the antennae (7, 11) having a solenoid (18, 19) as sole coil are consecutively arranged along the longitudinal axis (8) of the measuring tube.

7. Nuclear magnetic flowmeter (1) according to claim 6, **characterized in that** at least two of the consecutive measuring sections (10, 13) of at least one of the antennae groups (21) are spaced by a measuring distance (22) parallel to the longitudinal axis (8) of the measuring tube for reducing inductive coupling of the two consecutive antennae (7, 11).

8. Nuclear magnetic flowmeter (1) according to claim 7, **characterized in that** at least two of the antennae (7, 11) spaced by one of the measuring distances (22) of at least one of the antennae groups (21) form a composite antenna with a composite measuring section (23), the composite measuring section (23) consists of the measuring sections (10, 13) of the antennae (7, 11) and the measuring distance (22), and the composite antenna has the same properties over the composite measuring section (23) as one of the two antennae (7, 11) over its respective measuring section (10, 13).

9. Nuclear magnetic flowmeter (1) according to any one of claims 1 to 8, **characterized in that** the antennae unit (6) has at least one tapped coil (24) having at least one tap (25, 26), the tap (25, 26) separates the tapped coil (24) into two coil sections and each of the coil sections forms one of the antennae (7, 11, 12).

10. Nuclear magnetic flowmeter (1) according to claim 9, **characterized in that** at least one of the tapped coils (24) is a solenoid, the magnetic field of the solenoid in the medium (3) flowing in the measuring tube (2) has at least one component parallel to the longitudinal axis (8) of the measuring tube and the solenoid is arranged around the medium (3) flowing in the measuring tube (2).

11. Nuclear magnetic flowmeter (1) according to claim 9 or 10, **characterized in that** at least one of the antennae (7, 11, 12) of at least one of the tapped coils (24) has a compensation antenna for compensation of the magnetic field from the magnetic field generator effective in the medium (3) outside of at least one of the measuring sections (10, 13, 14) of the antennae formed by the tapped coil (24).

12. Nuclear magnetic flowmeter (1) according to any one of claims 4 to 11, **characterized in that** the single coil of at least one of the antennae (11, 12) is a saddle coil (27, 28) and the magnetic field of the saddle coil (27, 28) in the medium (3) flowing in the measuring tube (2) has at least one component perpendicular to the longitudinal axis (8) of the measuring tube.

13. Nuclear magnetic flowmeter (1) according to claim 12, **characterized in that** the antennae unit (6) has at least one pair of antennae, the pair of antennae has two antennae (11, 12) each having a saddle coil (27, 28) as sole coil, the two antennae (11, 12) having a saddle coil (27, 28) as single coil are opposite one another in respect to the longitudinal axis (8) of the measuring tube, the measuring sections (13, 14) of the two antennae (11, 12) are congruent, the direction of the magnetic field of the pair of antennae in the medium (3) is described by an axis (29) of the pair of antennae and the axis (29) of the pair of antennae has at least one component perpendicular to the longitudinal axis (8) of the measuring tube.

**14.** Nuclear magnetic flowmeter (1) according to claim 13, **characterized in that** the antennae unit (6) has at least two pairs of antennae, the axes of the antennae pairs (29) of the two pairs of antennae are oriented differently and the measuring sections (13, 14) of the pairs of antennae are at least overlapping.

**15.** Nuclear magnetic flowmeter (1) according to any one of claims 1 to 14, **characterized in that** at least one of the antennae (7, 11, 12) is designed for generating a magnetic field, a magnetic field strength of the magnetic field has a gradient and the magnetic field in the medium extends over the measuring section (10, 13, 14) of the at least one antenna (7, 11, 12).

**16.** Method for operating a nuclear magnetic flowmeter (1) according to claim 1,

**characterized in**
**that** excitation signals are generated by the measuring unit (5),
**that** excitation signals are transmitted by the antenna (7) to the flowing, magnetized medium (3) located in the measuring section (10) and the measuring signals excited by excitation signals in the medium (3) from the medium (3) located in the measuring section (10) are detected by the antenna (7),
**that** excitation signals are transmitted by the at least one further antenna (11, 12) to the flowing, magnetized medium (3) located in the at least one further measuring section (13, 14) and the measuring signals excited by the excitation signals in the medium (3) from the medium (3) located in the at least one further measuring section (13, 14) are detected by the at least one further antenna (11, 12),
**that** derived measuring signals with at least reduced influence by dephasing are formed in that the measuring signals detected by the antenna (7) and the measuring signals detected by the at least one further antenna (11, 12) are combined with one another,
**that** the measuring section (10, 13, 14) of the antenna and the measuring section (10, 13, 14) of the other antenna (7, 11, 12) have different lengths, and that the velocity of the flowing medium (3) is determined from the derived measuring signals.

**17.** Method according to claim 16, **characterized in that** the derived measuring signals are quotients, that each of the quotients is formed from the measuring signal detected by one of the antennae (7, 11, 12) and from the measuring signal detected by one of the remaining antennae (7, 11, 12).

**18.** Method according to claim 16 or 17, **characterized in that** the excitation signals are transmitted to the medium (3) by the antenna (7, 10, 11) and by at least one of the further antennae (7, 10, 11) at the same time.

**Revendications**

**1.** Débitmètre nucléaire magnétique (1) permettant de déterminer le débit d'un milieu en écoulement à travers un tube de mesure (2), comprenant un dispositif de génération de champ magnétique (4), un dispositif de mesure (5) et un dispositif d'antenne (6) doté d'une antenne (7),

le dispositif de génération de champ magnétique (4) faisant traverser sur un trajet de champ magnétique (9) aligné en parallèle à l'axe longitudinal de tube de mesure (8) le milieu en écoulement (3) par un champ magnétique présentant au moins une composante verticale à l'axe longitudinal de tube de mesure (8) afin de magnétiser le milieu (3),
le dispositif de mesure (5) étant réalisé pour générer des signaux d'excitation excitant le milieu magnétisé (3) et pour mesurer les signaux de mesure provoqués par les signaux d'excitation dans le milieu magnétisé (3),
l'antenne (7) étant réalisée en forme de bobine et étant réalisée, sur un trajet de mesure (10) aligné en parallèle à l'axe longitudinal de tube de mesure (8) et se trouvant sur le trajet de champ magnétique (9), pour transmettre les signaux d'excitation au milieu magnétisé (3) et pour détecter les signaux de mesure,
le dispositif d'antenne (6) présentant au moins une autre antenne (11, 12),
l'autre antenne (11, 12) étant réalisée en forme de bobine et étant réalisée, sur un autre trajet de mesure (13, 14) aligné en parallèle à l'axe longitudinal de tube de mesure (8) et se trouvant sur le trajet de champ magnétique (9), pour transmettre les signaux d'excitation au milieu magnétisé (3) et pour détecter les signaux de mesure, et le trajet de mesure (10) et l'autre trajet de mesure (13, 14) étant différents,

**caractérisé en ce que** les trajets de mesure (10, 13, 14) d'au moins deux des antennes (7, 11, 12) sont de longueur différente.

2. Débitmètre nucléaire magnétique (1) selon la revendication 1, **caractérisé en ce que** les densités d'enroulement d'au moins deux des antennes (7, 11, 12) réalisées en forme de bobine sont identiques.

3. Débitmètre nucléaire magnétique (1) selon la revendication 1 ou 2, **caractérisé en ce que** les longueurs des trajets de mesure (10, 13, 14) d'au moins deux des antennes (7, 11, 12) augmentent dans la direction d'écoulement du milieu (3).

4. Débitmètre nucléaire magnétique (1) selon l'une quelconque des revendications 1 à 3, **caractérisé en ce qu'**au moins l'une des antennes (7, 11, 12) présente une bobine unique pour transmettre les signaux d'excitation au milieu magnétisé (3) et pour détecter les signaux de mesure.

5. Débitmètre nucléaire magnétique (1) selon la revendication 4, **caractérisé en ce que** la bobine unique d'au moins l'une des antennes (7, 11, 12) présentant une bobine unique est une bobine cylindrique (18, 19, 20), le champ magnétique de la bobine cylindrique (18, 19, 20) dans le milieu en écoulement (3) dans le tube de mesure (2) présente au moins une composante parallèle à l'axe longitudinal de tube de mesure (8), et la bobine cylindrique (18, 19, 20) est disposée autour du milieu en écoulement (3) dans le tube de mesure (2).

6. Débitmètre nucléaire magnétique (1) selon la revendication 5, **caractérisé en ce que** le dispositif d'antenne (6) présente au moins un groupe d'antennes (21), le groupe d'antennes (21) présente au moins deux antennes (7, 11) présentant une bobine cylindrique (18, 19) comme bobine unique, et les trajets de mesure (10, 13) des antennes (7, 11) présentant une bobine cylindrique (18, 19) comme bobine unique sont disposés successivement le long de l'axe longitudinal de tube de mesure (8).

7. Débitmètre nucléaire magnétique (1) selon la revendication 6, **caractérisé en ce qu'**au moins deux des trajets de mesure successifs (10, 13) d'au moins l'un des groupes d'antennes (21) sont espacés par un trajet d'espacement de mesure (22) en parallèle à l'axe longitudinal de tube de mesure (8) pour réduire le couplage inductif des deux antennes successives (7, 11) .

8. Débitmètre nucléaire magnétique (1) selon la revendication 7, **caractérisé en ce qu'**au moins deux des antennes (7, 11) espacées par l'un des trajets d'espacement de mesure (22) d'au moins l'un des groupes d'antenne (21) forment une antenne composite dotée d'un trajet de mesure composite (23), le trajet de mesure composite (23) est composé des trajets de mesure (10, 13) des antennes (7, 11) et des trajets d'espacement de mesure (22), et l'antenne composite présente sur le trajet de mesure composite (23) les mêmes propriétés qu'une des deux antennes (7, 11) sur son trajet de mesure (10, 13) respectif.

9. Débitmètre nucléaire magnétique (1) selon l'une quelconque des revendications 1 à 8, **caractérisé en ce que** le dispositif d'antenne (6) présente au moins une bobine à prises (24) dotée d'au moins une prise (25, 26), la prise (25, 26) divisant la bobine à prises (24) en deux bobines partielles, et chacune des bobines partielles forme l'une des antennes (7, 11, 12).

10. Débitmètre nucléaire magnétique (1) selon la revendication 9, **caractérisé en ce qu'**au moins l'une des bobines à prises (24) est une bobine cylindrique, le champ magnétique de la bobine cylindrique présente dans le milieu en écoulement (3) dans le tube de mesure (2) au moins une composante parallèle à l'axe longitudinal de tube de mesure (8), et la bobine cylindrique est disposée autour du milieu en écoulement (3) dans le tube de mesure (2).

11. Débitmètre nucléaire magnétique (1) selon la revendication 9 ou 10, **caractérisé en ce qu'**au moins l'une des antennes (7, 11, 12) d'au moins l'une des bobines à prises (24) présente une antenne de compensation pour compenser le champ magnétique agissant par le dispositif de génération de champ magnétique (4) dans le milieu (3) à l'extérieur d'au moins l'un des trajets de mesure (10, 13, 14) des antennes (7, 11, 12) formées par la bobine à prises (24) .

12. Débitmètre nucléaire magnétique (1) selon l'une quelconque des revendications 4 à 11, **caractérisé en ce que** la bobine unique d'au moins l'une des antennes (11, 12) est une bobine en sellette (27, 28), et le champ magnétique de la bobine en sellette (27, 28) dans le milieu en écoulement (3) dans le tube de mesure (2) présente au moins une composante perpendiculaire à l'axe longitudinal de tube de mesure (8).

**13.** Débitmètre nucléaire magnétique (1) selon la revendication 12, **caractérisé en ce que** le dispositif d'antenne (6) présente au moins une paire d'antennes, la paire d'antennes présente deux des antennes (11, 12) présentant une bobine en sellette (27, 28) comme bobine unique, les deux antennes (11, 12) présentant une bobine en sellette (27, 28) comme bobine unique sont opposées par rapport à l'axe longitudinal de tube de mesure (8), les trajets de mesure (13, 14) des deux antennes (11, 12) sont coïncidents, la direction du champ magnétique de la paire d'antennes dans le milieu (3) est décrite par un axe de paire d'antennes (29), et l'axe de paire d'antennes (29) présente au moins une composante perpendiculaire à l'axe longitudinal de tube de mesure (8).

**14.** Débitmètre nucléaire magnétique (1) selon la revendication 13, **caractérisé en ce que** le dispositif d'antenne (6) présente au moins deux paires d'antennes, les axes de paire d'antennes (29) des deux paires d'antennes sont orientés différemment, et les trajets de mesure (13, 14) des paires d'antennes se chevauchent au moins.

**15.** Débitmètre nucléaire magnétique (1) selon l'une quelconque des revendications 1 à 14, **caractérisé en ce qu'**au moins l'une des antennes (7, 11, 12) est réalisée pour générer un champ magnétique, l'intensité de champ magnétique du champ magnétique présente un gradient, et le champ magnétique s'étend dans le milieu au moins sur le trajet de mesure (10, 13, 14) de ladite au moins une antenne (7, 11, 12) .

**16.** Procédé permettant de faire fonctionner un débitmètre nucléaire magnétique (1) selon la revendication 1,

> **caractérisé**
> **en ce que** le dispositif de mesure (5) génère des signaux d'excitation,
> **en ce que** des signaux d'excitation sont transmis par l'antenne (7) au milieu magnétisé (3) en écoulement qui se trouve sur le trajet de mesure (10), et les signaux de mesure provoqués par les signaux d'excitation dans le milieu (3) provenant du milieu (3) se trouvant sur le trajet de mesure (10) sont détectés par l'antenne (7),
> **en ce que** des signaux d'excitation sont transmis par ladite au moins une autre antenne (11, 12) au milieu magnétisé (3) en écoulement qui se trouve sur ledit au moins un autre trajet de mesure (13, 14), et les signaux de mesure provoqués par les signaux d'excitation dans le milieu (3) provenant du milieu (3) se trouvant sur ledit au moins un autre trajet de mesure (13, 14) sont détectés par ladite au moins une autre antenne (11, 12),
> **en ce que** les signaux de mesure dérivés sont formés par le déphasage avec au moins une influence réduite en ce que les signaux de mesure détectés par l'antenne (7) et les signaux de mesure détectés par ladite au moins une autre antenne (11, 12) sont associés les uns aux autres,
> **en ce que** le trajet de mesure (10, 13, 14) de l'antenne et le trajet de mesure (10, 13, 14) de l'antenne restante (7, 11, 12) sont de longueur différente, et
> **en ce que** la vitesse du milieu (3) en écoulement est déterminée à partir des signaux de mesure dérivés.

**17.** Procédé selon la revendication 16, **caractérisé en ce que** les signaux de mesure dérivés sont des quotients, **en ce que** chacun des quotients est formé à partir du signal de mesure détecté par l'une des antennes (7, 11, 12) et à partir du signal de mesure détecté par l'une des antennes restantes (7, 11, 12).

**18.** Procédé selon la revendication 16 ou 17, **caractérisé en ce que** les signaux d'excitation sont transmis au milieu (3) en même temps par l'antenne (7, 11, 12) et par au moins l'une des autres antennes (7, 11, 12).

Fig. 1

Fig. 2

Fig. 3a

Fig. 3b

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 7872474 B2
- US 4638251 A1
- SU 819657 A1
- US 20120092007 A1